(19)

Europäisches
Patentamt
European
Patent Office
Office européen
des brevets

(11) **EP 3 982 538 A1**

(12) **EUROPEAN PATENT APPLICATION**

(43) Date of publication:
**13.04.2022   Bulletin 2022/15**

(21) Application number: **20201209.2**

(22) Date of filing: **12.10.2020**

(51) International Patent Classification (IPC):
**H03K 7/08** (2006.01)          **H05B 6/06** (2006.01)

(52) Cooperative Patent Classification (CPC):
**H03K 7/08; H05B 6/062**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ELECTROLUX APPLIANCES
AKTIEBOLAG**
**105 45 Stockholm (SE)**

(72) Inventors:
• **VIROLI, Alex**
  **47122 Forli (IT)**
• **NOSTRO, Massimo**
  **47122 Forli (IT)**

• **ZANGOLI, Massimo**
  **47122 Forli (IT)**
• **CORSI, Giacomo**
  **47122 Forli (IT)**
• **URGESE, Emanuel**
  **47122 Forli (IT)**
• **ANGELI, Fabio**
  **47122 Forli (IT)**
• **MENGOZZI, Alan**
  **47122 Forli (IT)**

(74) Representative: **Electrolux Group Patents**
**AB Electrolux**
**Group Patents**
**S:t Göransgatan 143**
**105 45 Stockholm (SE)**

(54) **OSCILLATION UNIT, INDUCTION COOKING APPLIANCE AND METHOD FOR OPERATING AN OSCILLATION UNIT**

(57)     The invention relates to an oscillation unit, in particular oscillation circuit (2), more in particular quasi-resonant oscillation circuit, for generating heating power for an induction cooking appliance (1), in particular for a domestic induction cooking appliance and/or an induction hob, the oscillation unit comprising a resonant tank (30), in particular a resonant circuit, for generating an electrical and/or magnetic field and/or heating power, the resonant tank (30) in particular connected to a first node (21), an, in particular single, switching element (35) connected to the resonant tank (30), in particular by the first node (21), and driven with switching signals for oscillating the resonant tank (30), a measuring unit (40) for measuring a first electrical parameter of the resonant tank (30), in particular for measuring a voltage ($V_{CE}$), more in particular for measuring a node voltage ($V_{CE}$) of the first node (21), and an estimating unit (45) for estimating a second electrical parameter, in particular an electrical power, of the resonant tank (30) based on the first electrical parameter, an induction cooking appliance and a method for operating an oscillation unit.

FIG 1

**Description**

The present invention relates to an oscillation unit, an induction cooking appliance and to a method for operating an oscillation unit.

For an induction cooking appliance, a controlling of the electrical operation of the induction cooking is advantageous. However, for controlling of the electrical operation, additional components are necessary.

It is an object of the invention to provide an improved, and preferably cost effective and/or flexible, oscillation unit, induction cooking appliance and method for operating an oscillation unit, which in particular allow a both efficient and/or cost effective and/or at least relatively precise controlling of the electrical operation of the induction cooking.

The object is solved in particular by the oscillation unit according to claim 1 and by an induction cooking appliance according to claim 10 and the method according to claim 13. Improvements are provided in the dependent claims.

The invention relates to an oscillation unit, in particular oscillation circuit, more in particular quasi-resonant oscillation circuit, for generating heating power for an induction cooking appliance, in particular for a domestic induction cooking appliance and/or an induction hob, the oscillation unit comprising

- a resonant tank, in particular a resonant circuit, for generating an electrical and/or magnetic field and/or heating power, the resonant tank in particular connected to a first node,
- an, in particular single, switching element connected to the resonant tank, in particular by or at the first node, and driven with switching signals for oscillating the resonant tank,
- a measuring unit for measuring a first electrical parameter of the resonant tank, in particular for measuring a voltage of the resonant tank, more in particular for measuring a node voltage of or at the first node, and
- an estimating unit for estimating a second electrical parameter, in particular an electrical power, of the resonant tank based on the first electrical parameter.

The advantage in the proposed solution is in particular that the components needed for the oscillation unit, in particular a measuring circuit, have or can have a lower footprint and lower costs, since the measuring circuit for the measured parameter can essentially only comprise, for an example with a measured voltage, a voltage divider aimed to scale the measured parameter to a voltage range that can be sensed by a control unit. On the other hand, as a further example, the components needed for measuring a voltage and an associated current on a shunt, for example, can require more costs and components, for example operational amplifiers and/or filters.

For generating heating power for an induction cooking appliance, the resonant tank in particular can receive a supply voltage, more in particular a bus supply voltage at a third node, in particular over a ground voltage at a second node. In addition, a switching element in particular oscillates the resonant tank by opening and closing a connection to a second node, in particular a ground node, with predetermined switching parameters and/or a predetermined switching frequency. The predetermined switching frequency can in particular be in a frequency range between 10kHz and 50 kHz, more in particular between 15kHz and 35 kHz, more in particular between 20kHz and 30 kHz. By varying the switching frequency and/or the switching parameters and/or by, in particular periodically, interrupting the switching operation, the power received by the resonant tank and/or transmitted from the resonant tank to a cooking vessel can be adjusted.

In particular embodiments, the resonant tank comprises at least a capacitive resonant element and an inductive resonant element. In particular, the capacitive resonant element and the inductive resonant element are connected at the first node and/or at a third node. In particular embodiments, the resonant circuit comprises at least one capacitor and at least one inductor, in particular at least one induction coil, as resonant elements.

In particular embodiments, the inductive resonant element is used to generate energy for heating a cooking vessel, which is in particular arranged above the inductive resonant element. In particular embodiments, the inductive resonant element comprises a resistance, so that a damped oscillation is obtained.

In particular embodiments, the capacitive resonant element and the inductive resonant element are operated in parallel or in series.

A resonant tank can in particular be an LC circuit, a resonant circuit, or a tank circuit. A resonant tank can in particular be an electric circuit consisting of an inductor and a capacitor connected together, parallel and/or in series. The resonant tank is storing and transmitting energy oscillating at the circuit's or tank's resonant frequency.

The oscillating frequency of the resonant tank can in particular be computed as $1/(2*pi*sqrt(L*C))$, wherein L is the inductance of the resonant tank and C is the capacitance of the resonant tank. The inductance is defined by the internal parameters of the inductor, in particular of the induction coil and of a cooking vessel arranged on the inductor.

The heating energy in a cooking vessel arranged on the inductor is generated by eddy currents in the cooking vessel which are caused by the magnetic fields of the inductor.

In particular embodiments, the switching unit, in particular switchably, connects the resonant tank and a reference voltage node, in particular the first node and a second node and/or comprises a switching element, in particular a transistor and/or a unidirectional element, in particular a diode, wherein in particular the transistor and/or the switching unit is an IGBT (insulated gate bipolar transistor), and/or wherein in particular the transistor and the diode are operated in parallel.

In particular embodiments, the switching element switches or is switchable between an opened state and a closed state.

In particular embodiments, in a closed state of the switching element, the resonant tank, in particular the capacitive resonant element and/or the inductive resonant element, is/are connected bidirectionally with the reference voltage node, ground node and/or second node.

In particular embodiments, in an opened state of the switching element, the resonant tank, in particular the capacitive resonant element and/or the inductive resonant element are at least partially floating and/or only connected unidirectionally with the second node, in particular the ground node or reference voltage node.

In particular embodiments, the diode allows current only to flow from the second node to the first node.

In particular embodiments, the transistor enables a bidirectional connection, so that current can flow in both directions, whereas the diode enables only an unidirectional connection, so that current can flow only in one direction. By the usage of the diode, negative voltages within the resonant tank and/or the inductor can preferably be avoided.

A quasi-resonant oscillation circuit is in particular an oscillation circuit wherein the oscillation circuit can, for excitation, only be switchably connected to one of the voltage nodes. In other words, preferably, only a single switching element exists which can connect the first node to a single voltage.

In particular embodiments, the measuring unit comprises a voltage measuring unit for measuring the voltages of the first node, in particular over the second node, as measuring result or first electrical parameter.

In particular embodiments, the measuring unit comprises a dividing means for dividing the measuring results, so that it does not exceed a predetermined evaluation range, in particular a range of 10V, preferably 5V.

In particular embodiments, the measuring unit comprises a sampling unit using a predetermined sampling rate for sampling the measuring result of the first node or the divided values, wherein in particular the sampling rate is at least twice the resonance frequency of the resonant tank, more in particular at least five times the resonance frequency of the resonant tank, more in particular at least ten times the resonance frequency of the resonant tank.

In particular embodiments, the estimating unit comprises at least one of

- a derivation unit for obtaining the derivative of the first electrical parameter based on the sampled first electrical parameter, in particular by applying numerical differentiation on the sampled first electrical parameter,
- a multiplying unit for obtaining a multiplication result by multiplying the sampled first electrical parameter with the derivative of the first electrical parameter and in particular a constant factor and
- an averaging means for obtaining an average value of the multiplication results for a predetermined time, in particular during an OFF time of the switching means.

The second electrical parameter is in particular the multiplication result or the average value.

In particular embodiments, the estimating unit comprises a look up table for obtaining the second electrical parameter based on the first electrical parameter.

In particular, the constant factor is the capacity of the capacitive resonant element. In particular, the second electrical parameter is an electrical power of the oscillation circuit.

In particular, an overall electrical power can be by obtained by multiplying the first and the third electrical parameter.

In particular, a weighted difference between the first electrical power and the second electrical parameter can be computed for obtaining an electrical power of the oscillation unit.

In particular, the estimating unit can consider the current state of the switching element. In particular, the second electrical parameter can only be computed when the switching element is in its opened state, in particular during its OFF time. In closed state, in particular during its ON time, however, no power can be measured, as the measured first parameter will at least essentially be zero.

Electrical power of the oscillation circuit is in particular the electrical power of the oscillation circuit consumed or received from the power supply connector supplied by the voltage supply unit, which is in turn supplied with electrical power by means of the mains input voltage and the mains input current. Electrical power of the oscillation circuit is in particular the electrical power of the oscillation circuit transmitted to a cooking vessel arranged on the inductive resonant element, in particular as heating power.

In particular embodiments, a supply measuring unit is connected with a power supply connector for receiving a supply voltage, in particular with a bus supply voltage, at a third node, in particular over a ground voltage at a second node.

In particular embodiments, the oscillation unit comprises a control unit for controlling the resonant tank by determining switching parameters, in particular based on the second electrical parameter and/or a requested power, so that the power of the inductive resonant element is controlled in a control loop and/or in a closed loop.

In particular, the control unit comprises

- a power determination unit for determining a requested power based on a requested power level and
- a power control unit for controlling the power of the resonant tank based on a/the requested power and the second electrical parameter.

In particular, the requested power is or can be the nominal or set value. In particular, the second electrical parameter is or can be the actual value of an indicator for the actual value of the control loop.

In particular, the control unit controls the resonant tank by adjusting at least one switching parameter, in particular the ON time and/or the OFF time. In particular, the ON time defines, during a switching period, how long the switch is in a closed state and the OFF time defines during the same switching period, how long the switch is in an opened state.

In particular, for controlling of the resonant tank, the ON time is adjusted. In particular, for controlling the subsequent OFF time, the resonance frequency and the corresponding period of the resonant tank is used, wherein the OFF time is determined in particular based on the voltage at the switching element. In particular, the OFF time is based on detecting a zero crossing of the voltage at the switching element.

A requested power is in particular determined and/or transmitted by a power requesting unit. The power requesting unit in particular comprises means, for example a rotary knob or a touch sensitive unit, in particular a touch slider, for adjusting the requested power, so that an operator can request an appropriate power depending on his/her preferences. In particular, the power requesting unit determines a power level, wherein the control unit comprises means for converting the power level into a requested power.

For supplying a requested power to a cooking vessel, it is advantageous if the actual power of the oscillating unit can be estimated, so that by using a closed loop, the power can be regulated. This is advantageous, as the actual power can vary based on the type, size and position of the cooking vessel. It is advantageous, if the power can be estimated by a single sensor, as in principle, a current sensor and a voltage sensor would be necessary to estimate the current power.

The ON time can be at least $5\mu s$, in particular at least $10\mu s$. The ON time can be lower than 35ps, in particular lower than 25ms. The ON time can vary, for example, between $10\mu s$ and 25ps.

The ON time can be at least $10\mu s$, in particular at least $20\mu s$. The ON time can be lower than 40ps, in particular lower than 30ms. The OFF time, for example, varies between $20\mu s$ and 30ps. The resonance frequency can be between 20kHz and 30kHz.

In particular embodiments, the first node is a switchable node and/or the second node is a ground node and/or the third node is a power supply node.

In particular, a node can be a junction in an electrical circuit. In particular, a node can be a voltage node in an electrical circuit.

The sum of currents flowing into that node can be considered as equal to the sum of currents flowing out of that node. The algebraic sum of currents in a network of conductors meeting at a node is zero. In addition, the voltage at or along a node is zero. A node can be split in the drawing.

In an oscillation circuit according to the invention, the first node is connected to and/or connects each of the resonant tank, the switching device and the measuring device.

In an oscillation circuit according to the invention, the second node is connected to and/or connects each of the capacitor, the switching device and the measuring device.

In an oscillation circuit according to the invention, the third node is connected to and/or connects each of the power supply and the resonant tank.

The invention relates to an induction cooking appliance, in particular domestic induction cooking appliance and/or induction hob, comprising

- one, at least one, two, at least two, four, at least four, six or at least six oscillation circuits according to the invention,
- a user interface for requesting a power for the, in particular quasi-resonant, oscillation circuit and
- a voltage supply unit for supplying voltage to the power supply connector of the oscillation circuit(s).

In an embodiment, the induction hob comprises four oscillation circuits, wherein each oscillation circuit comprises an inductor, as well as a user interface for requesting power from each of the inductors.

A domestic induction cooking appliance is in particular an induction cooking appliance which is specifically designed for use in household and/or at home. Such devices in particular have considerably different requirements compared to professional cooking appliances, for example cost and/or usability and/or space requirements.

A domestic induction cooking appliance is or can be in particular not an induction cooking appliance which is specifically designed for professional use, for example in canteen kitchens, restaurants or in general for commercial cooking.

In particular, the voltage supply unit comprises a bridge rectifier, more in particular a diode a bridge rectifier and/or a bus capacitor.

The voltage supply unit is in particular, more in particular only, supplied with power by a one-phase power supply, which in particular means that the voltage supply unit is supplied with power by a phase connector and neutral connector, which in particular supply power from an AC power supply with a frequency of about 50 to 60 Hz and a voltage of about 100 to 240 V.

In particular, the induction cooking appliance comprises a supply measuring unit for measuring the/a third electrical parameter, in particular an input current of the voltage supply unit.

The invention relates to an oscillation unit, in particular oscillation circuit, more in particular quasi-resonant oscillation circuit, for generating heating power for an induction cooking appliance, in particular for a domestic induction cooking appliance and/or an induction hob, the oscillation unit comprising a resonant tank, in particular a resonant circuit, for generating an electrical and/or magnetic field and/or heating power.

The heating power generated by such an oscillation unit can in particular be configured to heat a heating zone.

The induction cooking appliance of the present invention may particularly be configured such that in at least one operation mode one or more than one heating zones form one cooking zone and/or are combined to one cooking zone, respectively. A cooking zone may be particularly provided as at least a portion of the cooking surface. Particularly, such a cooking zone is associated with at least one heating zone. Additionally, or alternatively, a cooking zone may be associated with more than one heating zone. Particularly, a cooking zone may be associated with an even number, particularly two, four, six, eight or ten, more particularly two, heating zones. Alternatively, a cooking zone may be associated with an uneven number, particularly three, five, seven or nine, more particularly three, heating zones.

Preferably, the induction cooking appliance of the present invention is configured such that a cooking zone comprises one or more than one heating zones, which can be driven with the same or different power, frequency or heating level.

In the present invention, it is preferred that in at least one operation mode of the induction cooking appliance according to the present invention is configured such that a cooking zone comprises at least two, preferably two, heating zones, driven by the same power, frequency or heating level. Particularly, such cooking zone comprises or is associated with at least two, preferably two, heating power-transferring elements.

Additionally, or alternatively, the induction cooking appliance of the present invention may be configured such that the number of heating zones associated with one cooking zone may vary and/or may be adjustable dependent on the needs of the cook and/or the size, form or kind of cookware placed on the cooking surface.

The invention further relates to a method for operating an oscillation unit, in particular according to the invention, in particular a quasi-resonant oscillation circuit, for generating heating power for an induction cooking appliance, in particular for a domestic induction cooking appliance and/or an induction hob, the method comprising

- generating, by a resonant tank, in particular a resonant circuit, an electrical and/or magnetic field and/or heating power, the resonant tank in particular connected to a first node,
- driving an, in particular single, switching element connected to the resonant tank, in particular by the first node, with switching signals for oscillating the resonant tank,
- measuring, by a measuring unit, a first electrical parameter of the oscillation circuit, in particular measuring a voltage (or: node voltage) of the first node, and
- estimating, by an estimating unit, a second electrical parameter, in particular an electrical power, of the oscillation circuit based on the first electrical parameter.

In particular embodiments, the method for operating an oscillation unit further comprises, in particular by the estimating unit,

- by a derivation unit, obtaining the derivative of the first electrical parameter based on the sampled first electrical parameter, in particular by applying numerical differentiation on the sampled first electrical parameter, and/or
- by a multiplying unit, obtaining a multiplication result by multiplying the sampled first electrical parameter with the derivative of the first electrical parameter and in particular a constant factor, and/or
- by an averaging means, obtaining an average value of the multiplication results for a predetermined time, in particular during an OFF time of the switching means.

In particular embodiments, the method for operating an oscillation unit comprises, in particular by the estimating unit,

- derivating, by a derivation unit, the first electrical parameter based on the sampled first electrical parameter for obtaining a derivative, in particular by applying numerical differentiation on the sampled first electrical parameter and/or

-   multiplying, by a multiplying unit, the sampled first electrical parameter with the derivative of the first electrical parameter and in particular a constant factor to obtain a multiplication result and/or
-   averaging, by an averaging means, the multiplication result for obtaining an average value for a predetermined time, in particular during an OFF time of the switching means, and/or
-   multiplying the first and a third electrical parameter for obtaining an overall electrical power and/or
-   computing a weighted difference between the overall electrical power and the second electrical parameter.

In particular, the second electrical parameter is or can be the multiplication result or the average value.

In particular, a look up table can obtain the second electrical parameter based on the first electrical parameter.

In particular, the constant factor is or can be the capacity of the capacitive resonant element. In particular, the second electrical parameter is or can be an electrical power of the oscillation circuit.

In particular, a first electrical power is or can be obtained by multiplying the first and the third electrical parameter and/or by a weighted difference between the first electrical power and the second electrical parameter.

In particular embodiments, the method for operating an oscillation unit further comprises by a control unit, controlling the resonant tank by determining switching parameters, in particular based on the second electrical parameter and/or a requested power, so that the power of the inductive resonant element is controlled in a control loop and/or in a closed loop.

In particular embodiments, the control unit comprises, by a power determination unit, determining a requested power based on a requested power level, and/or by a power control unit, controlling the power of the resonant tank based on a/the requested power and the second electrical parameter.

In particular, the requested power is or can be the nominal or set value and wherein the second electrical parameter is the actual value of the control loop.

In particular, the oscillation unit is controlled by adjusting at least one switching parameter, in particular the ON time and/or the OFF time. The ON time preferably defines, during a switching period, how long the switch is in a closed state and the OFF time defines during the same switching period, how long the switch is in an opened state.

In particular, for controlling of the resonant tank, the ON time is adjusted and/or, in particular, for controlling a subsequent OFF time, the resonance frequency and the corresponding period of the resonant tank is used. The OFF time is preferably determined based on the voltage at the switching element and/or, in particular, the OFF time is based on detecting a zero crossing of the voltage at the switching element.

The present invention will be described in further detail with reference to the drawings, in which

FIG 1   shows an oscillation unit according to an embodiment of the present invention,

FIG 2   shows an induction cooking appliance according to an embodiment of the present invention and

FIG 3   shows an induction cooking appliance according to an embodiment of the present invention.

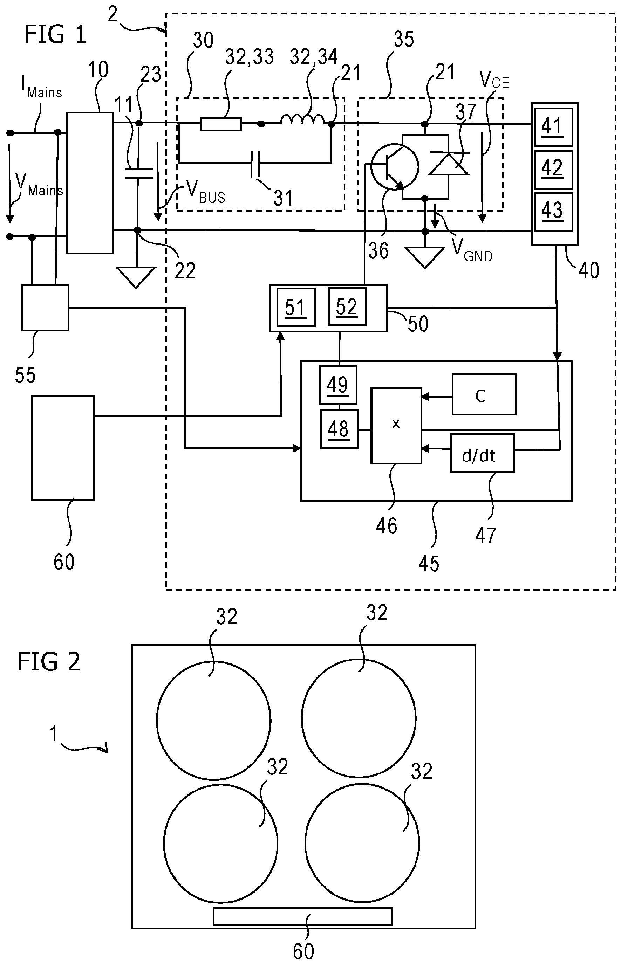

FIG. 1 shows a quasi-resonant oscillation circuit 2 for generating heating power for an induction cooking appliance 1, for a domestic induction cooking appliance as an induction hob.

The oscillation unit 2 comprises a resonant tank 30, as a resonant circuit, for generating an electrical field and/or magnetic field and correspondingly a heating power for a not shown cooking vessel arranged on the oscillation unit 2. The resonant tank 30 is connected to a first node 21 of the oscillation unit 2.

The oscillation unit 2 comprises a single switching element 35 connected to the resonant tank 30, by the first node 21. The oscillation unit is driven with switching signals for oscillating the resonant tank 30.

The oscillation unit 2 comprises a measuring unit 40 for measuring a first electrical parameter of the resonant tank 30, in particular for measuring a node voltage $V_{CE}$ of the first node 21 and/or across the switching element 35.

The oscillation unit 2 comprises an estimating unit 45 for estimating a second electrical parameter, in particular an electrical power or an indicator for the electrical power, of the resonant tank 30 based on the first electrical parameter.

For generating heating power for an induction cooking appliance, the resonant tank 30 receives a supply voltage, in particular a bus supply voltage VBUS at a third node 23, in particular over a ground voltage VGND at a second node 22. The resonant tank 30 is connected to the first node 21 and to the third node 23.

In addition, a switching element 35 oscillates the resonant tank by opening and closing with predetermined switching parameters and/or a predetermined switching frequency. The predetermined switching frequency can in particular be in a frequency range between 10kHz and 50 kHz, more in particular between 15kHz and 35 kHz, more in particular between 20kHz and 30 kHz or between 25kHz and 30 kHz.

By varying the switching frequency and/or the switching parameters, the power received and/or transmitted by the resonant tank can be adjusted. In addition or alternatively, by periodically interrupting the switching operation, the power received and/or transmitted by the resonant tank can be adjusted.

The resonant tank 30 comprises at least a capacitive resonant element 31 and an inductive resonant element 32. The capacitive resonant element 31 and the inductive resonant element 32 are connected at the first node 21 and at a third node 23.

The resonant circuit comprises a capacitor 31 and an inductor 32, in particular at least one induction coil 32, as resonant elements. The inductive resonant element 32 is used to generate energy for heating a not shown cooking vessel.

The inductive resonant element 32 comprises a resistance 33, so that a damped oscillation is obtained. The capacitive resonant element 31 and the inductive resonant element 32 are operated in parallel, but might be also operated in series.

The inductive resonant element 32 is in the circuit represented by an inductive element 34 in series with a resistant element 33. As an alternative, the inductive resonant element 32 can, in the circuit be represented by an inductive element in parallel with a resistant element.

In specific, not shown embodiments, the resonant tank 30 also might be constituted by two or more resonant tanks 30 operated in parallel, which are alternately activated by a two-sided toggle switch.

A resonant tank can be an LC circuit, a resonant circuit, tank circuit, or tuned circuit. A resonant tank can be an electric circuit consisting of an inductor and a capacitor connected together, parallel and/or in series. The resonant tank is storing and transmitting energy oscillating at the circuit's or tank's resonant frequency.

The oscillating frequency of the resonant tank can be computed as $1/(2*pi*sqrt(L*C))$, wherein L is the inductance of the resonant tank and C is the capacitance of the resonant tank. The inductance is defined by the internal and/or external parameters of the inductor, in particular of the induction coil itself and of a cooking vessel arranged on the inductor. The heating energy in the cooking vessel is generated by eddy currents caused by the magnetic fields of the inductor in the cooking vessel.

The switching unit 35 switchably connects the resonant tank 30 and a reference voltage node, in FIG. 1 the first node 21 and a second node 22. The switching unit 35 comprises a switching element 35, in particular a transistor 36 and a unidirectional element, in particular a diode 37. In the embodiment, the transistor 36 is an IGBT (insulated gate bipolar transistor), and the transistor 36 and the diode 37 are operated in parallel.

The switching element 35 switches and is switchable between an opened state and a closed state.

In the closed state of the switching element 35, the resonant tank, formed by the capacitive resonant element 31 and the inductive resonant element 32, is connected bidirectionally with the reference voltage node or second node 22.

In an opened state of the switching element 35, the resonant tank, in FIG. 1 the capacitive resonant element 31 and the inductive resonant element 32 are at least partially floating, only connected unidirectionally with the second node 22. The diode 37 allows current only to flow from the second node 22 to the first node 21.

The transistor 36 enables a bidirectional connection, so that current can flow in both directions, whereas the diode 37 enables only an unidirectional connection, so that current can flow only in one direction. By the usage of the diode, negative voltages within the inductor can be avoided.

A quasi-resonant oscillation circuit is an oscillation circuit wherein the oscillation circuit can, for excitation, only be switchably connected to one of the voltage nodes. In other words, in FIG. 1, only a single switching element exists which can connect the first node 21 only to a single voltage $V_{GND}$.

The measuring unit 40 comprises a voltage measuring means 41 for measuring the voltages of the first node 21, over the second node 22, as measuring result or first electrical parameter.

The measuring unit 40 comprises a dividing means 42 for dividing the measuring results, so that it does not exceed a predetermined evaluation range.

The measuring unit 40 comprises a sampling unit 43 using a predetermined sampling rate for sampling the measuring result of the first node 21 or the divided values. The sampling unit can be accompanied by a filter unit, in particular to filter out high frequencies from the signal received from the dividing means 42 or from the measuring means 41.

In the embodiment, the sampling rate is at least twice the resonance frequency of the resonant tank, in particular at least five times the resonance frequency of the resonant tank, more in particular at least ten times the resonance frequency of the resonant tank.

The estimating unit 45 comprises a derivation unit 47 for obtaining the derivative of the first electrical parameter based on the sampled first electrical parameter, in the embodiment by applying numerical differentiation on the sampled first electrical parameter.

The estimating unit 45 further comprises a multiplying unit 46 for obtaining a multiplication result by multiplying the sampled first electrical parameter with the derivative of the first electrical parameter and in particular a constant factor.

The estimating unit 45 also comprises an averaging means 48 for obtaining an average value of the multiplication results for a predetermined time, during an OFF time of the switching means 35.

The second electrical parameter is the multiplication result or the average value. The second electrical parameter can also be obtained by a look up table for obtaining the second electrical parameter based on the first electrical parameter.

The constant factor is the capacity C of the capacitive resonant element 31. In the embodiment, the second electrical parameter is an electrical power of the oscillation circuit.

The second electrical parameter is obtained based on a first electrical power by multiplying the first and the third electrical parameter and/or by based on a weighted difference between the first electrical power and the second electrical parameter.

The estimating unit 45 also considers the current state of the switching element 35. In the embodiment, the second electrical parameter is only computed when the switching element 35 is in the opened state, and hence during its OFF time. In closed state, during its ON time, however, no power can be measured, as the measured first parameter will at least essentially be zero.

Electrical power of the oscillation circuit is in particular the electrical power of the oscillation circuit consumed or received from the power connector. Electrical power of the oscillation circuit is in particular the electrical power of the oscillation circuit transmitted to a cooking vessel arranged on the inductive resonant element.

The oscillation unit comprises a power supply connector 22, 23 for receiving a bus supply voltage $V_{BUS}$ at a third node 23, in particular over a ground voltage $V_{GND}$ at a second node 22.

The oscillation unit 2 comprises a control unit 50 for controlling the resonant tank 30 by determining switching parameters, based on the second electrical parameter and a requested power, so that the power of the inductive resonant element is controlled in a control loop and/or in a closed loop, respectively.

The control unit 50 comprises a power determination unit 51 for determining a requested power based on a requested power level.

The control unit 50 comprises a power control unit 52 for controlling the power of the resonant tank 30 based on the requested power and the second electrical parameter.

In the control loop, the requested power corresponds to the nominal or set value and the second electrical parameter corresponds to the actual value of the control loop.

The control unit 50 performs a power control by adjusting at least one switching parameter, in particular the ON time and/or the OFF time. The ON time defines, during a switching period, how long the switch is in a closed state and the OFF time defines during the same switching period, how long the switch is in an opened state.

For controlling of the resonant tank 30, the ON time is adjusted. For controlling the subsequent OFF time the resonance frequency and the corresponding period of the resonant tank 30 is used, whereas the OFF time is determined based on the voltage at the switching element. In particular, the OFF time is based on detecting a zero crossing of the voltage at the switching element.

A requested power is in particular determined and/or transmitted by a power requesting unit. The power requesting unit in particular comprises means, for example a rotary knob, for adjusting the requested power, so that an operator can request an appropriate power depending on his preferences. The power requesting unit determines a power level, wherein the control unit 50 comprises means for converting the power level into a requested power.

For supplying a requested power to a cooking vessel, it is advantageous if the actual power can be estimated, so that by using a closed loop, the power can be regulated. This is advantageous, as the actual power can vary based on the type, size and position of the cooking vessel. It is advantageous, if the power can be estimated by a single sensor, as in principle, a current sensor and a voltage sensor would be necessary to estimate the current power.

The ON time can be at least 5μs, in particular at least 10μs. The ON time can be lower than 35ps, in particular lower than 25ms. The ON time can vary between 10μs and 25ps.

The OFF time can be at least 10μs, in particular at least 10μs. The OFF time can be lower than 40μs, in particular lower than 30ms. The OFF time varies between 20μs and 30μs.

The resonance frequency can be between 20kHz and 30kHz.

The first node 21 is a switchable node and/or the second node 22 is a ground node and/or the third node 23 is a power supply node.

A node according to the invention can in particular be a connection point where or by which at least two different components, means or units are connected electrically. In particular, this can be a set of electrically connected wires which have hence the same voltage or potential.

In particular, a node can be a junction in an electrical circuit. In particular, a node can be a voltage node in an electrical circuit.

The sum of currents flowing into that node can be considered as equal to the sum of currents flowing out of that node. The algebraic sum of currents in a network of conductors meeting at a node is zero. In addition, the voltage at or along a node is zero.

In an oscillation circuit 2 according to the invention, the first node 21 is connected to each of the resonant tank, the switching device and the measuring device.

In an oscillation circuit 2 according to the invention, the second node 22 is connected to each of the capacitor, the switching device and the measuring device.

In an oscillation circuit 2 according to the invention, the third node 23 is connected to each of the power supply and the resonant tank.

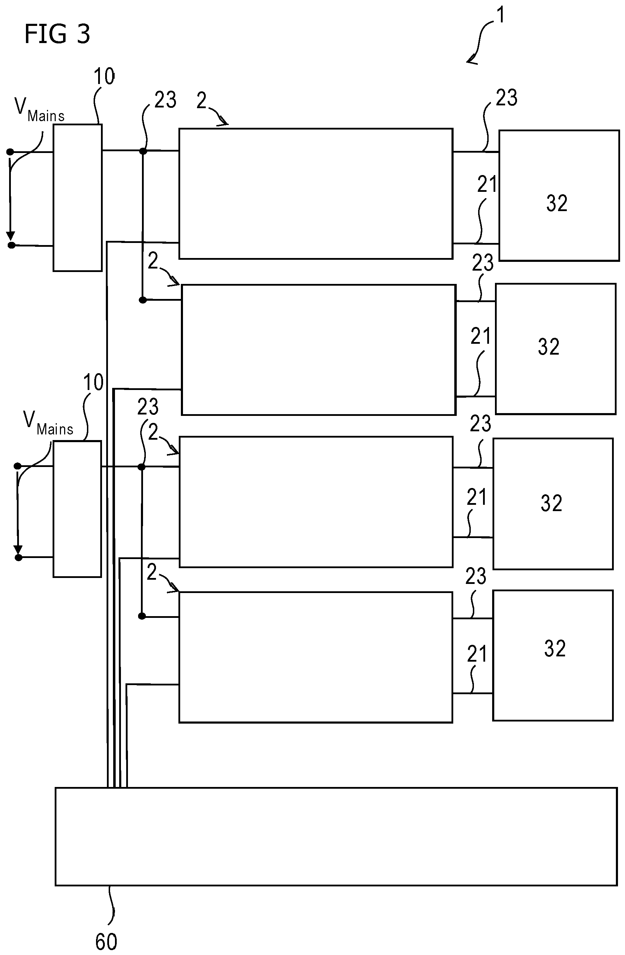

FIG. 2 and 3 show an induction cooking appliance 1, in particular domestic induction cooking appliance and/or induction hob, comprising one, at least one, two, at least two, four, at least four, six or at least six oscillation circuits.

The induction cooking appliance 1 comprises a user interface 60 for requesting a power for the quasi-resonant oscillation circuit.

The induction cooking appliance 1 comprises a voltage supply unit 10 for supplying voltage to the power supply connector of the oscillation circuits.

In an embodiment, the induction hob 1 comprises four oscillation circuits, which each comprise an inductor, as well as a user interface 60 for requesting power from each of the inductors.

A domestic induction cooking appliance is in particular an induction cooking appliance which is specifically designed for use in household and/or at home. Such devices have considerably different requirements compared to professional cooking appliances, for example cost and/or usability and/or space requirements. A domestic induction cooking appliance is in particular not an induction cooking appliance which is specifically designed for professional use, for example in canteen kitchens, restaurants or in general for commercial cooking.

The voltage supply unit 10 comprises a bridge rectifier and/or a bus capacitor 11.

The voltage supply unit 10 is in particular, more in particular only, supplied with power by a one-phase power supply, which in particular means that the voltage supply unit 10 is supplied with power by a phase connector and neutral connector, which in particular supply power from an AC power supply with a frequency of about 50 to 60 Hz and a voltage of about 100 to 240 V.

The induction cooking appliance 1 comprises a supply measuring unit 55 for measuring the third electrical parameter, in particular an input current of the voltage supply unit 10.

As an example, FIG 3 shows four oscillation units 2 according to the invention, wherein a first power supply 10 supplies power from a first voltage phase to two oscillation units 2 by means of a first DC bus. A second power supply 10 supplies power from a second voltage phase to two oscillation units 2 by means of a second DC bus.

In a more general approach, a first power supply 10 supplies power from a first voltage phase to at least two oscillation units 2, for example by means of a first DC bus. A second power supply 10 supplies power from a second voltage phase to at least two oscillation units 2, for example by means of a second DC bus.

The shown circuits hence provide a method for operating an oscillation circuit 2, in particular a quasi-resonant oscillation circuit, for generating heating power for an induction cooking appliance 1, in particular for a domestic induction cooking appliance and/or an induction hob, the oscillation circuit comprising a resonant tank 30, in particular a resonant circuit, for generating heating power, connected to a first node 21, and an, in particular single, switching element 35 connected to the first node 21, and driven with a predetermined switching frequency for oscillating the resonant tank 30.

The method for operating the oscillation circuit 2 comprises

- by a measuring unit 40, measuring a first electrical parameter of the oscillation circuit 2, for measuring a node voltage $V_{CE}$ of the first node 21, and
- by an estimating unit 45, estimating a second electrical parameter, as an electrical power, of the oscillation circuit 2 based on the first electrical parameter.

For operating an oscillation, in the estimating unit, the derivation unit 47 obtains the derivative of the first electrical parameter based on the sampled first electrical parameter, in particular by applying numerical differentiation on the sampled first electrical parameter.

The multiplying unit 46 obtains a multiplication result by multiplying the sampled first electrical parameter with the derivative of the first electrical parameter and in particular a constant factor.

The averaging means 48 obtains an average value of the multiplication results for a predetermined time, in particular during an OFF time of the switching means.

In the embodiment, the second electrical parameter is the multiplication result or the average value.

As an alternative or in addition, a look up table can obtain the second electrical parameter based on the first electrical parameter.

In the embodiment, the constant factor is or can be the capacity of the capacitive resonant element. In particular, the second electrical parameter is an electrical power of the oscillation circuit.

In the embodiment, a first electrical power can also be obtained by multiplying the first and the third electrical parameter and/or by a weighted difference between the first electrical power and the second electrical parameter.

In a method for operating an oscillation unit, a control unit 50 controls the resonant tank by determining switching parameters, in particular based on the second electrical parameter and a requested power, so that the power of the inductive resonant element is controlled in a control loop and/or in a closed loop,

In the embodiment, the control unit comprises

- by a power determination unit 51, determining a requested power based on a requested power level, and
- by a power control unit 52, controlling the power of the resonant tank based on a/the requested power and the second electrical parameter.

In the embodiment, the requested power is the nominal or set value and wherein the second electrical parameter is the actual value of the control loop.

In particular, the oscillation unit 2 is controlled by adjusting at least one switching parameter, in particular the ON time and/or the OFF time. The ON time preferably defines, during a switching period, how long the switch is in a closed state and the OFF time defines during the same switching period, how long the switch is in an opened state.

In the embodiment, for controlling of the resonant tank 30, the ON time is adjusted. For controlling a subsequent OFF time, the resonance frequency and the corresponding period of the resonant tank is or can be used. The OFF time is preferably determined based on the voltage at the switching element. In particular, the OFF time is or can be based on detecting a zero crossing of the voltage at the switching element 35.

The quasi-resonant resonant tank 2, which can also be called an induction generator, produces power based on a working routine with the two phases Ton as ON time and Toff as OFF time.

During the Ton phase, the IGBT as switching unit 35 is closed and current flows through it, accumulating power in the inductor 32. The voltage VCE is short-circuited to ground 22 so its value is 0.

During the Toff phase, instead, the IGBT 35 is open so that current and voltage resonate in the tank 2. The voltage VCE over the IGBT comprises a decaying sinusoidal behavior

$$- \text{VCE} = V\text{IN} * exp(-\alpha t) * \sin(\omega t + \varphi \text{IN}),$$

wherein VIN is the input voltage of the rectified mains supply signal, $\omega$ is the angular frequency, t is the time, and $\varphi$IN is the input angle of the rectified mains supply signal.

By means of a fast sampling of the voltage VCE across the switching element, a control or estimation unit, for example a CPU, can reassemble the shape of the sinusoidal decay. From the latter, useful information can be gathered, such as maximum peak, minimum peak, period or decaying factor.

Since, during the Toff phase, the voltage is directly linked to the current through the relation $i = C^*$dv/dt, said features carry information also on the current, as the capacitance C is fixed.

Information on the current during the Ton phase is also encoded in the shape of VCE, as the initial conditions of the Toff phase define the parameters $V$IN and $\varphi$IN. Furthermore, the Ton value is known as it is determined by the driving algorithm. So, by acquiring the shape of the voltage Vce, information on the current both in Ton and Toff phase is available.

Having established this framework, different embodiments of the present disclosure may use different ways to compute power depending on the specific requirements. For instance, a look-up table approach can have the benefit of avoiding heavy computation but can be cumbersome from the memory point of view; on the other hand, an equation-solving technique limits the usage of memory but might require computational power.

The optional presence of the input current IMAINS can in particular be exploited to enhance the robustness of the power estimate. If only one resonant tank, in particular generator, is running, the final power value can be obtained as a weighted average between the estimation from the sampled voltages VCE and the estimation from the input current IMAINS. By means of tests, the weights can be chosen according to the evaluated robustness of each estimation.

Otherwise, if more than one resonant tank, in particular generator, is running, the total power estimate computed from the input current IMAINS can be still used. For instance, if the sum of the power estimations obtained by sampled voltages VCE exceeds the total power estimate of the input current IMAINS by a predetermined value, for example 10%, and the robustness of the two estimate has been validated equal, so that the same weights between the sampled voltages VCE and the input current IMAINS have been selected, the power estimates of each generator can be modified by a predetermined value, for example 5% as 10% / 2 where 2 can be chosen because the weights are the same.

**List of reference numerals**

| 1 | Induction hob |
| 2 | Oscillation circuit |
| 10 | Voltage supply unit |

| | |
|---|---|
| 11 | Bus capacitor |
| 21 | First node |
| 22 | Second node |
| 23 | Third node |
| 30 | Resonant tank |
| 31 | Capacitive resonant element |
| 32-34 | Inductive resonant element |
| 35-37 | Switching element |
| 40-43 | Measuring unit |
| 41 | Voltage measuring means |
| 42 | Dividing means |
| 43 | Sampling unit |
| 45-49 | Estimating unit |
| 46, 49 | Multiplying unit |
| 47 | Derivation unit |
| 48 | Averaging means |
| 50 | Control unit |
| 51 | Power determination unit |
| 52 | Power control unit |
| 55 | Measuring unit |
| 60 | User interface |

| | |
|---|---|
| IMAINS | Mains current |
| VBUS | Supply voltage |
| VCE | Voltage across switching element |
| VGND | Ground voltage |
| VMAINS | Mains voltage |

**Claims**

1. Oscillation unit, in particular oscillation circuit (2), more in particular quasi-resonant oscillation circuit, for generating heating power for an induction cooking appliance (1), in particular for a domestic induction cooking appliance and/or an induction hob, the oscillation unit comprising

   - a resonant tank (30), in particular a resonant circuit, for generating an electrical and/or magnetic field and/or heating power, the resonant tank (30) in particular connected to a first node (21),
   - an, in particular single, switching element (35) connected to the resonant tank (30), in particular by the first node (21), and driven with switching signals for oscillating the resonant tank (30),
   - a measuring unit (40) for measuring a first electrical parameter of the resonant tank (30), in particular for measuring a voltage ($V_{CE}$), more in particular for measuring a node voltage ($V_{CE}$) of the first node (21), and
   - an estimating unit (45) for estimating a second electrical parameter, in particular an electrical power, of the resonant tank (30) based on the first electrical parameter.

2. Oscillation unit according to claim 1,
   wherein the resonant tank (30) comprises at least a capacitive resonant element (31) and an inductive resonant element (32, 33), in particular connected at the first node (21) and/or at a third node (23),
   in particular wherein the resonant circuit comprises at least one capacitor (31) and at least one inductor (32), in particular at least one induction coil (32), as resonant elements,
   in particular wherein the inductive resonant element (32) is used to generate energy for heating a cooking vessel.

3. Oscillation unit according to claim 1 and/or 2,
   wherein the inductive resonant element (32) comprises a resistance (33), so that a damped oscillation is obtained, in particular wherein the capacitive resonant element (31) and the inductive resonant element (32) are operated in parallel or in series.

4. Oscillation unit according to any of the preceding claims,
   wherein the switching unit (35), in particular switchably, connects the resonant tank (30) and a reference voltage node, in particular the first node (21) and a second node (22), and/or comprises a switching element (35), in particular a transistor (36), and/or a unidirectional element, in particular a diode (37), wherein in particular the switching unit (35) is an IGBT (insulated gate bipolar transistor), and/or wherein in particular the transistor (36) and the diode (37) are operated in parallel, and/or

wherein the switching element (35) switches or is switchable between an opened state and a closed state, and/or wherein in the closed state of the switching element (35), the resonant tank, in particular the capacitive resonant element (31) and/or the inductive resonant element (32, 33), is/are connected bidirectionally with the reference voltage node or second node (22), and/or

wherein in an opened state of the switching element (35), the resonant tank, in particular the capacitive resonant element (31) and/or the inductive resonant element (32, 33) are at least partially floating, only connected unidirectionally with the second node (22), and/or

wherein the diode (37) allows current only to flow from the second node (22) to the first node (21).

5. Oscillation unit according to any of the preceding claims, wherein the measuring unit (40) comprises

a voltage measuring unit (41) for measuring the voltages of the first node (21), in particular over the second node (22), as measuring result or first electrical parameter, and/or

a dividing means (42) for dividing the measuring results, so that in particular the measuring results do not exceed a predetermined evaluation range, and/or

a sampling unit (43) using a predetermined sampling rate for sampling the measuring result of the first node (21) or the divided values, wherein in particular the sampling rate is at least twice the resonance frequency of the resonant tank, more in particular at least five times the resonance frequency of the resonant tank, more in particular at least ten times the resonance frequency of the resonant tank.

6. Oscillation unit according to any of the preceding claims, wherein the estimating unit (45) comprises

- a derivation unit (47) for obtaining the derivative of the first electrical parameter based on the sampled first electrical parameter, in particular by applying numerical differentiation on the sampled first electrical parameter, and/or

- a multiplying unit (46) for obtaining a multiplication result by multiplying the sampled first electrical parameter with the derivative of the first electrical parameter and in particular a constant factor, and/or

- an averaging means (48) for obtaining an average value of the multiplication results for a predetermined time, in particular during an OFF time of the switching means (35), and/or

- a multiplying unit (49) for obtaining an overall electrical power by multiplying the first and the third electrical parameter and/or

- a weighting unit for obtaining a weighted difference between the overall electrical power and the second electrical parameter, and/or

- a look up table for obtaining the second electrical parameter based on the first electrical parameter,

- wherein in particular the constant factor is the capacity (C) of the capacitive resonant element (31), and/or

- wherein the second electrical parameter is the multiplication result or the average value, and/or

- wherein in particular the second electrical parameter is an electrical power of the oscillation circuit.

7. Oscillation unit according to any of the preceding claims, comprising a power supply connector (22, 23) for receiving a supply voltage, in particular a bus supply voltage ($V_{BUS}$) at a third node (23), in particular over a ground voltage ($V_{GND}$) at a second node (22).

8. Oscillation unit according to any of the preceding claims, comprising a control unit (50) for controlling the resonant tank (30) by determining switching parameters, in particular based on the second electrical parameter and/or a requested power, so that the power of the inductive resonant element is controlled in a control loop and/or in a closed loop, wherein in particular the control unit (50) comprises

- a power determination unit (51) for determining a requested power based on a requested power level, and/or

- a power control unit (52) for controlling the power of the resonant tank (30) based on a/the requested power and the second electrical parameter,

- the controlling of the power in particular by adjusting at least one switching parameter, in particular the ON time and/or the OFF time,

- wherein, in particular, for controlling of the resonant tank (30), the ON time of the switching element (35) is adjusted and/or

- wherein, in particular, for controlling a subsequent OFF time, the resonance frequency and the corresponding period of the resonant tank (30) is determined, and/or
- wherein, in particular, the OFF time is preferably determined based on the voltage at the switching element and/or
- wherein, in particular, the OFF time is based on detecting a zero crossing of the voltage at the switching element,
- wherein, in particular, the ON time defines, during a switching period, how long the switching element is in a closed state and the OFF time defines during the same switching period, how long the switching element is in an opened state and/or
- wherein, in particular, the requested power is the nominal or set value of the control loop and wherein the second electrical parameter is the actual value of the control loop.

9. Oscillation unit according to any of the preceding claims, wherein the first node (21) is a switchable node and/or wherein the second node (22) is a ground node and/or wherein the third node (23) is a power supply node.

10. Induction cooking appliance, in particular domestic induction cooking appliance and/or induction hob, comprising

- one, at least one, two, at least two, four, at least four, six or at least six oscillation circuits according to any of claims 1 to 9,
- a user interface (60) for requesting a power for the quasi-resonant oscillation circuit and/or
- at least one voltage supply unit (10) for supplying voltage to a power supply connector (23, 22) of the oscillation circuit(s) (2) .

11. Induction cooking appliance according to claim 10,
wherein the at least one voltage supply unit (10) comprises a bridge rectifier and/or a bus capacitor (11).

12. Induction cooking appliance according to any of claims 10 or 11, comprising

- a supply measuring unit (55) for measuring the third electrical parameter, in particular an input current (IMAINS) of the voltage supply unit (10).

13. Method for operating an oscillation unit (2), in particular according to one of claims 1 to 9, in particular a quasi-resonant oscillation circuit, for generating heating power for an induction cooking appliance (1), in particular for a domestic induction cooking appliance and/or an induction hob, the method comprising

- generating, by a resonant tank (30), in particular a resonant circuit, an electrical and/or magnetic field and/or heating power, the resonant tank (30) in particular connected to a first node (21),
- driving an, in particular single, switching element (35) connected to the resonant tank (30), in particular by the first node (21), with switching signals for oscillating the resonant tank (30),
- measuring, by a measuring unit (40), a first electrical parameter of the oscillation circuit (2), in particular measuring a node voltage ($V_{CE}$) of the first node (21), and
- estimating, by an estimating unit (45), a second electrical parameter, in particular an electrical power, of the oscillation circuit (2) based on the first electrical parameter.

14. Method for operating an oscillation unit (2) according to claim 13, further comprising, in particular by the estimating unit (45),

- derivating, by a derivation unit (47), the first electrical parameter based on the sampled first electrical parameter for obtaining a derivative, in particular by applying numerical differentiation on the sampled first electrical parameter and/or
- multiplying, by a multiplying unit (46), the sampled first electrical parameter with the derivative of the first electrical parameter and in particular a constant factor to obtain a multiplication result and/or
- averaging, by an averaging means (48), the multiplication result for obtaining an average value for a predetermined time, in particular during an OFF time of the switching means (35), and/or
- multiplying the first and a third electrical parameter for obtaining an overall electrical power and/or
- computing a weighted difference between the overall electrical power and the second electrical parameter and/or
- obtaining, by a look up table, the second electrical parameter based on the first electrical parameter,
- wherein in particular the constant factor is the capacity (C) of the capacitive resonant element (31) and/or
- wherein in particular the second electrical parameter is the multiplication result or the average value and/or

- wherein in particular the second electrical parameter is an electrical power of the oscillation circuit and/or an indicator for an electrical power of the oscillation circuit.

**15.** Method for operating an oscillation unit (2) according to claim 13 or 14, further comprising
controlling, by a control unit (50), the resonant tank (30) by determining switching parameters for the switching signal, in particular based on the second electrical parameter and/or a requested power, so that the power of the inductive resonant element and/or the resonant tank is controlled in a control loop and/or in a closed loop,
wherein in particular the controlling by the control unit (50) comprises

- determining, by a power determination unit (51), a requested power based on a requested power level, and/or
- controlling, by a power control unit (52), the power of the resonant tank (30) based on a/the requested power and the second electrical parameter, and/or
- in particular wherein the requested power is the nominal or set value and/or wherein the second electrical parameter is the actual value of the control loop, and/or
- in particular wherein the resonant tank, more in particular its actual power, is controlled by adjusting at least one switching parameter, more in particular the ON time and/or the OFF time, wherein in particular the ON time defines, preferably during a switching period, how long the switching element is in a closed state and/or the OFF time defines, in particular during the same switching period, how long the switching element is in an opened state, and/or
- in particular wherein, for controlling of the resonant tank (30), the ON time is adjusted and/or wherein, for controlling a subsequent OFF time, the resonance frequency and the corresponding period of the resonant tank (30) is determined, whereas the OFF time is preferably determined based on the voltage at the switching element and/or wherein, more in particular, the OFF time is based on detecting a zero crossing of the voltage at the switching element.

**FIG 1**

$I_{Mains}$

$V_{Mains}$

10

11

23

30

32,33 32,34 21

35

21

$V_{CE}$

37

41

42

43

40

2

$V_{BUS}$

31

22

36

$V_{GND}$

55

51 52

50

49

48

C

x

d/dt

46

47

45

60

**FIG 2**

32

32

1

32

32

60

FIG 3

Europäisches
Patentamt

European
Patent Office

Office européen
des brevets

## EUROPEAN SEARCH REPORT

Application Number

EP 20 20 1209

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 525 485 A1 (WHIRLPOOL CO [US]) 21 November 2012 (2012-11-21) * paragraph [0002] - paragraph [0050]; figures 1-10 * ----- | 1-15 | INV. H03K7/08 H05B6/06 |
| X | US 5 450 305 A (BOYS JOHN T [NZ] ET AL) 12 September 1995 (1995-09-12) * column 1, line 21 - column 11, line 35; figures 1-11e * ----- | 1-15 | |
| X | EP 2 330 866 A2 (EGO ELEKTRO GERAETEBAU GMBH [DE]) 8 June 2011 (2011-06-08) * paragraph [0002] - paragraph [0061]; figures 1-4 * ----- | 1-15 | |

TECHNICAL FIELDS SEARCHED (IPC)

H03K
H05B
G06F

The present search report has been drawn up for all claims

| Place of search | Date of completion of the search | Examiner |
|---|---|---|
| Munich | 19 March 2021 | Kassner, Holger |

EPO FORM 1503 03.82 (P04C01)

17

## ANNEX TO THE EUROPEAN SEARCH REPORT
## ON EUROPEAN PATENT APPLICATION NO.

EP 20 20 1209

19-03-2021

| Patent document cited in search report | | | Publication date | Patent family member(s) | | | Publication date |
|---|---|---|---|---|---|---|---|
| EP | 2525485 | A1 | 21-11-2012 | EP | 2525485 | A1 | 21-11-2012 |
| | | | | ES | 2586575 | T3 | 17-10-2016 |
| | | | | PL | 2525485 | T3 | 31-08-2017 |
| US | 5450305 | A | 12-09-1995 | AU | 656803 | B2 | 16-02-1995 |
| | | | | JP | 3178837 | B2 | 25-06-2001 |
| | | | | JP | H06509904 | A | 02-11-1994 |
| | | | | KR | 0163412 | B1 | 15-04-1999 |
| | | | | US | 5450305 | A | 12-09-1995 |
| | | | | WO | 9304527 | A1 | 04-03-1993 |
| EP | 2330866 | A2 | 08-06-2011 | CN | 102186271 | A | 14-09-2011 |
| | | | | DE | 102009047185 | A1 | 01-06-2011 |
| | | | | EP | 2330866 | A2 | 08-06-2011 |
| | | | | ES | 2609584 | T3 | 21-04-2017 |
| | | | | JP | 5586433 | B2 | 10-09-2014 |
| | | | | JP | 2011113977 | A | 09-06-2011 |
| | | | | PL | 2330866 | T3 | 28-04-2017 |
| | | | | US | 2011120989 | A1 | 26-05-2011 |

EPO FORM P0459

For more details about this annex : see Official Journal of the European Patent Office, No. 12/82